# EUROPEAN PATENT SPECIFICATION

(11) **EP 3 457 370 B1**
(45) Date of publication and mention of the grant of the patent: **14.10.2020**
(21) Application number: 18179000.7
(22) Date of filing: 21.06.2018
(51) Int. Cl.: G08B 21/12, F04B 35/04, B06B 1/00

(54) **OPERATING AND INFORMATION TRANSMITTING SYSTEM FOR ACTUATING AND SENSING MODULE**
BETRIEBS- UND INFORMATIONSÜBERTRAGUNGSSYSTEM FÜR BETÄTIGUNGS- UND ABTASTMODUL
SYSTÈME DE TRANSMISSION D'INFORMATIONS ET DE CONTROLE POUR MODULE D'ACTIONNEMENT ET DE DÉTECTION

(30) Priority: 27.07.2017 TW 106125323
(43) Date of publication of application: 20.03.2019
(73) Proprietor: Microjet Technology Co., Ltd., Hsinchu (TW)
(72) Inventor: Mou, Hao-Jan, Hsinchu (TW); Hsueh, Ta-Wei, Hsinchu (TW); Mo, Li-Pang, Hsinchu (TW); Chen, Shih-Chang, Hsinchu (TW); Lin, Ching-Sung, Hsinchu (TW); Huang, Chi-Feng, Hsinchu (TW); Han, Yung-Lung, Hsinchu (TW)
(74) Representative: Uexküll & Stolberg

(56) References cited:
- US-A1- 2007 069 905
- US-A1- 2014 134 053
- US-A1- 2014 349 707
- US-A1- 2016 171 869

## Description

### FIELD OF THE INVENTION

The present disclosure relates to an environmental monitoring system for an actuating and sensing module, and more particularly to a driving and information transmitting system for an actuating and sensing module.

### BACKGROUND OF THE INVENTION

Nowadays, people pay much attention to monitoring environmental air quality in daily living, e.g., monitoring carbon monoxide, carbon dioxide, volatile organic compounds (VOC), PM2.5, and so on. The exposure of these gases or substances in the environment can cause human health problems or can even harm the life. Therefore, it has become an important issue for every country to develop and implement environmental air quality monitoring technology.

Generally, it is feasible to use a sensor to monitor the air quality in the environment. If the sensor can further provide immediate monitored information for the people in the environment, the people can be alerted to take precautions or escape promptly, thus the negative influence on human body and injury to the health caused by the exposure to the harmful gas are prevented. In this regard, the sensor is suitably used for monitoring the environment.

Regarding using the sensor to monitor the environment and provide related data to the user, the monitoring sensitivity and the precision of the sensor should be taken into consideration. If the air in the environment is transferred to the sensor through natural convection, the flowrate of the airflow is not stable. Under this circumstance, the result of monitoring the environment is usually not accurate, and the response time of the sensor is long. In other words, the real-time monitoring efficacy is low.

Nowadays, there are large-scale environmental monitoring base stations provided to monitor environmental air quality. However, those base stations are only suitable for monitoring air quality in a large area, which are unable to promptly monitor the quality of the air surrounding a human being with precision and efficiency, e.g., the indoor air quality or the ambient air close to the human being. If the sensor is integrated into a portable electronic device, the air quality can be real-time monitored in everywhere and at any time. Moreover, the monitored data can be transmitted to a cloud database in real time for database construction and data integration. Consequently, the monitored data of the air quality can be more accurately and immediately provided for enabling an air quality notification mechanism and an air quality processing mechanism.

Therefore, there is a need of providing a driving and information transmitting system for an actuating and sensing module for increasing the monitoring accuracy of the sensor, increasing the monitoring speed of the senor, immediately monitoring the air quality in everywhere and at any time, transmitting the monitored data to the cloud database for fetching more accurate and prompt air quality information, and enabling the air quality notification mechanism and the air quality processing mechanism according to the air quality information.

US 2016/171869 A1 disclosed techniques for using synthetic jet technology as an air delivery device for sensing applications. In particular, a synthetic jet device is used to deliver a controlled airflow or other fluidic flow to a sensor measurement area. Such a sensing system can be used to detect accurate concentration of target features present in the ambient surroundings, such as gases, particles, solutions, mixtures, and any other environmental features that can be sensed from a controlled airflow. An example application is air quality monitoring by using one or more synthetic jet devices to deliver a known or otherwise controlled airflow to a sensing area, thereby allowing for detection of harmful or otherwise unacceptable concentrations of particulate matter, gases, or air pollutants. In some embodiments, a synthetic jet device is operatively coupled with a sensor via a flow channel in a common housing, so as to provide a controlled flow sensing system.

### SUMMARY OF THE INVENTION

The invention is characterized by the appended claims. An object of the present disclosure provides a driving and information transmitting system for an actuating and sensing module. The system includes an actuating and sensing device and a power supply device. The actuating and sensing device includes at least one sensor, at least one actuating device, a microprocessor, a power controller and a data transceiver, in which those components are integrated as a modular structure. The actuating device is used for driving the fluid to flow at a stable flowrate, so that the sensor is provided with the fluid flow in consistent amount and can directly sense the fluid in shorter response time. Therefore, the sensor acquires accurate and precise sensing results. The actuating and sensing device is not necessarily equipped with a power source since it is in connection with the power supply device of the system. Therefore, the installation space of the overall modular structure is saved and the purpose of miniaturizing the modular structure is achieved, so that the actuating and sensing device is suitably applied to an electronic device for monitoring the air quality.

Another object of the present disclosure provides a driving and information transmitting system for an actuating and sensing module, using a data transceiver to receive a control command, and enabling the sensor to perform a sensing operation and enabling the actuating device according to the control command. After a monitored data sensed by the sensor is transmitted to the microprocessor, the monitored data is processed into an output data by the microprocessor. The output data is transmitted by the data transceiver to the connection device, so that the information carried by the output data can be displayed, stored and transmitted by the connection device. Consequently, the purpose of immediately displaying the monitoring information and immediately issuing the notification signal are achieved. Moreover, the output data can be transmitted to a cloud database for database construction and data integration. Consequently, the more immediate and accurate monitoring information is provided for enabling an air quality notification mechanism and an air quality processing mechanism.

In accordance with an aspect of the present disclosure, a driving and information transmitting system for an actuating and sensing module is provided. The system includes an actuating and sensing device, a power supply device and a connection device. The actuating and sensing device includes at least one sensor, at least one actuating device, a microprocessor, a power controller and a data transceiver. The power supply device transfers an energy to the power controller, so that the power controller receives the energy and enables the at least one sensor and the at least one actuating device. After a monitored data sensed by the at least one sensor is transmitted to the microprocessor, the monitored data is processed into an output data by the microprocessor. The output data is received by the data transceiver, and the output data is transmitted from the data transceiver to the connection device. A control command from the connection device is received by the data transceiver, and the control command is transmitted to the microprocessor to enable the sensor to perform a sensing operation and enable the actuating device.

The above contents of the present disclosure will become more readily apparent to those ordinarily skilled in the art after reviewing the following detailed description and accompanying drawings, in which:

### BRIEF DESCRIPTION OF THE DRAWINGS

FIG. 1 schematically illustrates the architecture of a driving and information transmitting system for an actuating and sensing module according to an embodiment of the present disclosure;
FIG. 2 is a schematic perspective view illustrating the structure of an actuating and sensing device of the driving and information transmitting system for the actuating and sensing module according to an embodiment of the present disclosure;
FIG. 3A is a schematic exploded view illustrating a fluid actuating device used in the actuating and sensing device of the present disclosure;
FIG. 3B is a schematic exploded view illustrating the fluid actuating device of FIG. 3A and taken along another viewpoint;
FIG. 4 is a schematic cross-sectional view illustrating the piezoelectric actuator of the fluid actuating device as shown in FIGS. 3A and 3B;
FIG. 5 is a schematic cross-sectional view illustrating the fluid actuating device as shown in FIGS. 3A and 3B; and
FIGS. 6A to 6E schematically illustrate the actions of the fluid actuating device of the actuating and sensing device according to the embodiment of the present disclosure.

### DETAILED DESCRIPTION OF THE PREFERRED EMBODIMENT

The present disclosure will now be described more specifically with reference to the following embodiments. It is to be noted that the following descriptions of preferred embodiments of this invention are presented herein for purpose of illustration and description only. It is not intended to be exhaustive or to be limited to the precise form disclosed.

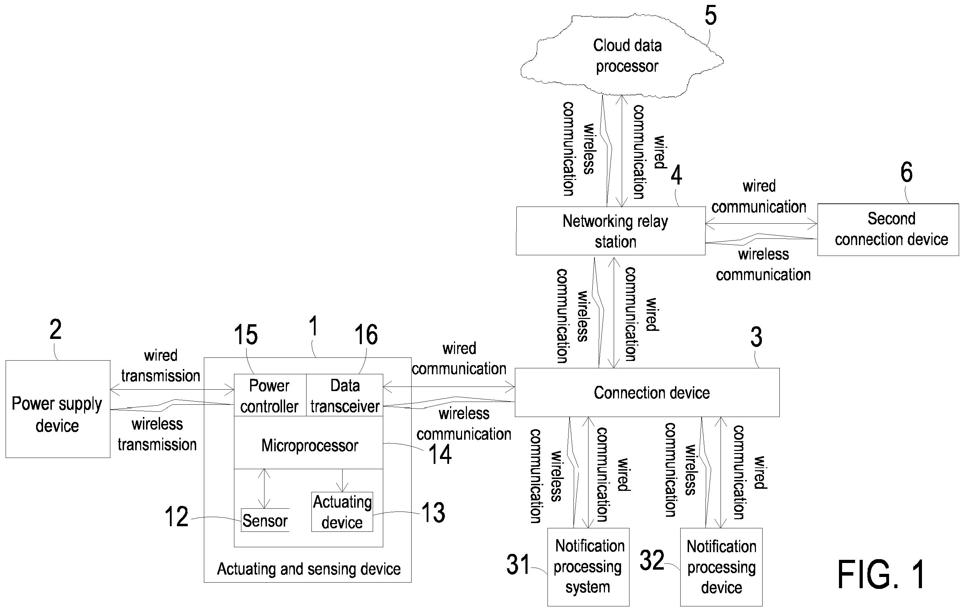

Please refer to FIG. 1. The present discourse provides a driving and information transmitting system for an actuating and sensing module, in which the driving and information transmitting system includes at least one actuating and sensing device 1, at least one sensor 12, at least one actuating device 13, at least one microprocessor 14, at least one power controller 15, at least one data transceiver 16, at least one power supply device 2, at least one energy, at least one connection device 3, at least one output data, and at least one control command. The number of the actuating and sensing device 1, the sensor 12, the actuating device 13, the microprocessor 14, the power controller 15, the data transceiver 16, the power supply device 2, the energy, the connection device 3, the output data and the control command is exemplified by one for each in the following embodiments but not limited thereto. It is noted that each of the actuating and sensing device 1, the sensor 12, the actuating device 13, the microprocessor 14, the power controller 15, the data transceiver 16, the power supply device 2, the energy, the connection device 3, the output data and the control command can also be provided in plural numbers.

As shown in FIG. 1, the driving and information transmitting system for the actuating and sensing module includes an actuating and sensing device 1, a power supply device 2 and a connection device 3. The actuating and sensing device 1 includes at least one sensor 12, at least one actuating device 13, a microprocessor 14, a power controller 15 and a data transceiver 16. The power controller 15 receives an energy and transfers the energy to enable the sensor 12 and the actuating device 13. The data transceiver 16 can receive or transmit data.

An example of the sensor 12 includes but is not limited to a temperature sensor, a volatile organic compound sensor (e.g., a sensor for measuring formaldehyde or ammonia gas), a particulate sensor (e.g., a PM2.5 particle sensor), a carbon monoxide sensor, a carbon dioxide sensor, an oxygen sensor, an ozone sensor, any other appropriate gas sensor, a humidity sensor, a water content sensor, a substance sensor (e.g., a sensor for measuring compounds or biological substances in liquid or air), a water quality sensor, any other appropriate liquid sensor, a light sensor, or the combination thereof.

In an embodiment, when the actuating device 13 is enabled to drive a fluid to pass through the sensor 12, the fluid is guided to the sensor 12 at a stable flowrate. Consequently, the sensor 12 can monitor the fluid directly to acquire the accurate result. Moreover, since the response time of the sensor 12 is reduced, the efficiency of monitoring the fluid is enhanced. In some embodiments, the fluid is a gas or a liquid, but not limited thereto.

The power supply device 2 transfers the energy to the power controller 15. After the power controller 15 receives the energy, the power controller 15 enables the sensor 12 and the actuating device 13. In some embodiments, the energy is a light energy, an electric energy, a magnetic energy, a sound energy or a chemical energy, but not limited thereto.

In an embodiment, the power supply device 2 transfers power to the power controller 15 in a wired transmission manner. For example, the power supply device 2 is a charger or a rechargeable battery capable of transferring energy to the power controller 15 in the wired transmission manner. In another embodiment, the power supply device 2 transfers power to the power controller 15 in a wireless transmission manner. For example, the power supply device 2 is a charger or a rechargeable battery equipped with a wireless charging component (or an inductive charging component) for transferring the energy to the power controller 15 in the wireless transmission manner. In further another embodiment, the power supply device 2 is a portable mobile device with wireless charging/discharging capability, e.g., a smart phone having a wireless charging component (or an inductive charging component), and the smart phone transfers the energy to the power controller 15 in the wireless transmission manner.

In an embodiment, the power controller 15 further includes a chargeable element (not shown) for receiving and storing the energy. The chargeable element of the power controller 15 receives the energy from the power supply device 2 transferred through a wired transmission path or a wireless transmission path. Then, the chargeable element stores the energy, and outputs the energy to the sensor 12 for powering the sensor 12 to perform a sensing operation.

The sensor 12 is used for monitoring the environment to acquire a monitored data. The microprocessor 14 processes and calculates the monitored data to convert the monitored data to an output data. The data transceiver 16 receives the output data, and sends it to the connection device 3 through transmission, so that the connection device 3 can display and store the information carried by the output data, or can transmit the information carried by the output data to a storage device (not shown) of the connection device 3 for storing or processing. In an embodiment, the connection device 3 is in communication with a notification processing system 31 to actively (i.e. directly notify) or passively (i.e. operated by a user to whom the information carried by the output data is provided) enable an air quality notification mechanism, e.g., an instant air quality map informs people to avoid away or to wear masks. In another embodiment, the connection device 3 is in communication with a notification processing device 32 to actively (i.e. directly operate) or passively (i.e. operated by a user to whom the information carried by the output data is provided) enable an air quality processing mechanism, e.g., an air cleaner or an air-conditioner is enabled to clean the air.

In an embodiment, the connection device 3 is a display device with a wired communication module (e.g., a desktop computer). In another embodiment, the connection device 3 is a display device with a wireless communication module (e.g., a notebook computer). In another embodiment, the connection device 3 is a portable electronic device with a wireless communication module (e.g., a mobile phone). For example, the wired communication module has an RS485 communication port, an RS232 communication port, a Modbus communication port or a KNX communication port, and the wireless communication module performs a wireless communication process according to a Zigbee communication technology, a Z-wave communication technology, an RF communication technology, a Bluetooth communication technology, a Wifi communication technology or an EnOcean communication technology.

The driving and information transmitting system for the actuating and sensing module further includes a networking relay station 4 and a cloud data processor 5. The connection device 3 sends the information carried by the output data to the networking relay station 4, after which the networking relay station 4 sends the information carried by the output data to the cloud data processor 5 to make it stored in and processed by the cloud data processor 5. The cloud data processor 5 processes the information carried by the output data to correspondingly issue a notification signal to the connection device 3 through the networking relay station 4. After the connection device 3 receives the notification signal, the notification processing system 31 connected with the connection device 3 receives the notification signal from the connection device 3, and accordingly enables an air quality notification mechanism. Alternatively, the notification processing device 32 connected with the connection device 3 receives the notification signal from the connection device 3, and accordingly enables an air quality processing mechanism.

In an embodiment, the connection device 3 issues a control command to the actuating and sensing device 1 so as to control the operation of the actuating and sensing device 1. Similarly, the control command is transmitted to the data transceiver 16 in the wired or wireless communication transmission manner as discussed above. Then the control command is transmitted to the microprocessor 14 to control the sensor 12 to perform the sensing operation and enable the actuating device 13.

In an embodiment, the driving and information transmitting system for the actuating and sensing module further includes a second connection device 6. The second connection device 6 issues the control command to the cloud data processor 5 through the networking relay station 4, then the control command is transmitted from the cloud data processor 5 to the connection device 3 through the networking relay station 4. After receiving the control command, the connection device 3 issues the control command to the data transceiver 16 of the actuating and sensing device 1. Then, the control command is transmitted to the microprocessor 14. According to the control command, the microprocessor 14 controls the sensor 12 to perform the sensing operation and enables the actuating device 13. In an embodiment, the second connection device 6 is a device with a wired communication module. In other embodiment, the second connection device 6 is a device with a wireless communication module. In another embodiment, the second connection device 6 is a portable electronic device with a wireless communication module, but not limited thereto.

The actuating device 13 is a driving device capable of driving an operated system in response to a control signal. An example of the actuating device 13 includes but is not limited to an electric actuating device, a magnetic actuating device, a thermal actuating device, a piezoelectric actuating device, and a fluid actuating device. For example, the electric actuating device is an electric actuating device of a DC motor, an AC motor or a step motor, the magnetic actuating device is an magnetic actuating device of a magnetic coil motor, the thermal actuating device is a thermal actuating device of a heat pump, the piezoelectric actuating device is a piezoelectric actuating device of a piezoelectric pump, and the fluid actuating device is a fluid actuating device of a gas pump or a liquid pump.

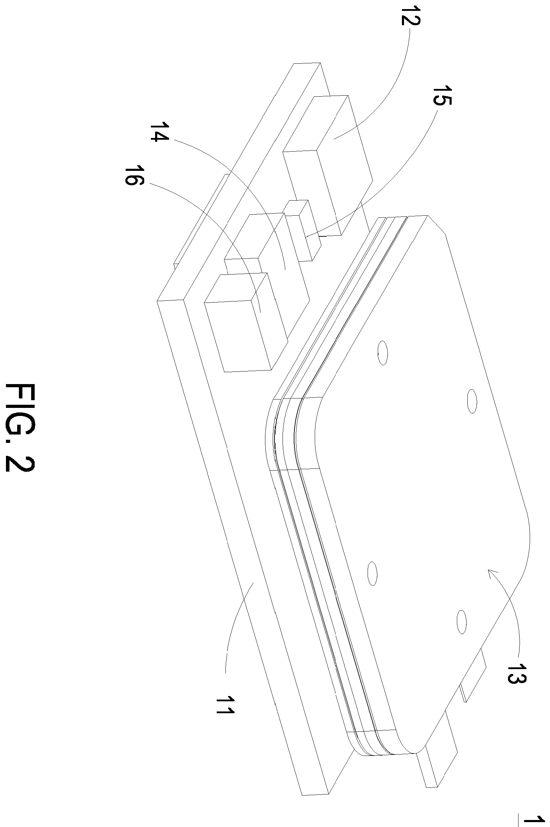

FIG. 2 is a schematic perspective view illustrating the structure of an actuating and sensing device of the driving and information transmitting system for the actuating and sensing module according to an embodiment of the present disclosure. The actuating and sensing device 1 further includes a carrier 11. The at least one sensor 12, the at least one actuating device 13, the microprocessor 14, the power controller 15 and the data transceiver 16 are integrated into the carrier 11 to be defined as a modular structure. In an embodiment, the carrier 11 is a substrate such as a printed circuit board (PCB). The sensor 12 and the fluid actuating device 13 are disposed on the carrier 11. In some other embodiments, the carrier 11 is an application-specific integrated circuit (ASIC) or a system on chip (SOC), wherein the sensor 12 is deposited on the carrier 11 and the actuating device 13 can be packaged on the carrier 11. That is, the carrier 11, the sensor 12 and the actuating device 13 are combined together as an integral structure. The profile and type of the carrier 11 are not restricted as long as the sensor 12 and the actuating device 13 are supported by the carrier 11.

In an embodiment, the actuating device 13 is a fluid actuating device. Preferably but not exclusively, the fluid actuating device 13 is a piezoelectric pump or a micro-electro-mechanical system (MEMS) pump. Hereinafter, the actions of the fluid actuating device 13 of a piezoelectric pump will be described as follows.

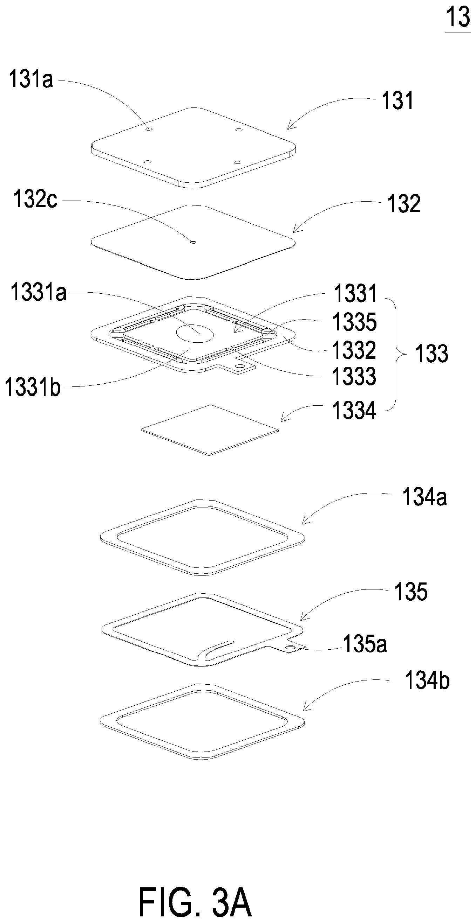

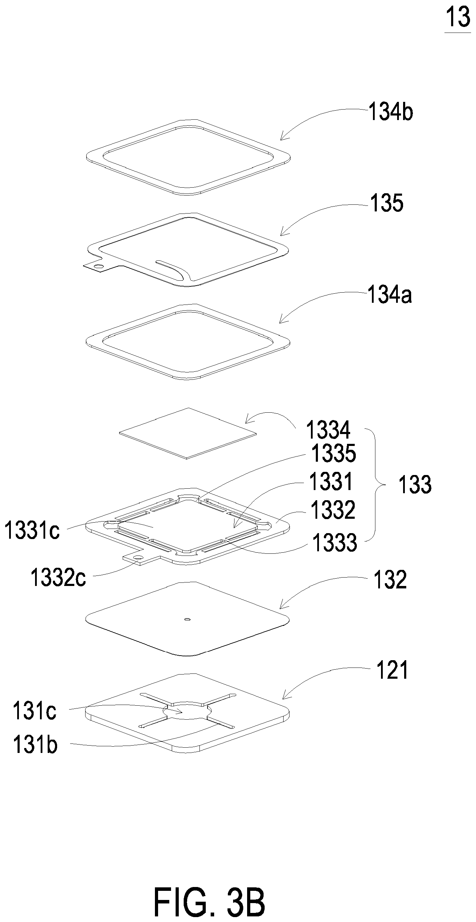

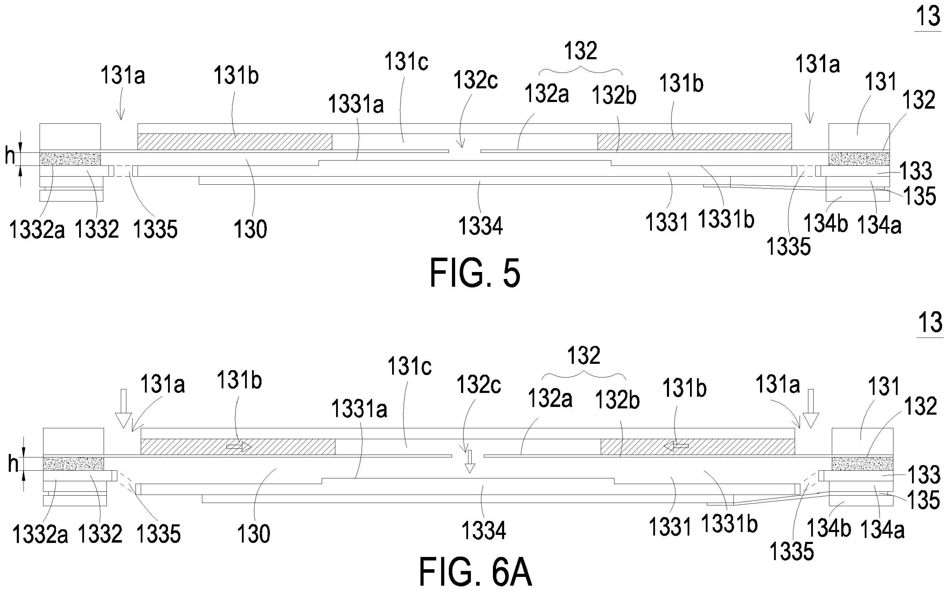

Please refer to FIGS. 3A and 3B. The fluid actuating device 13 includes a fluid inlet plate 131, a resonance plate 132, a piezoelectric actuator 133, a first insulation plate 134a, a conducting plate 135 and a second insulation plate 134b. The piezoelectric actuator 133 is aligned with the resonance plate 132. The fluid inlet plate 131, the resonance plate 132, the piezoelectric actuator 133, the first insulation plate 134a, the conducting plate 135 and the second insulation plate 134b are stacked on each other sequentially. After the above-mentioned components are combined together, the cross-sectional view of the resulting structure of the fluid actuating device 13 is shown in FIG. 5.

The fluid inlet plate 131 has at least one inlet 131a. Preferably but not exclusively, the fluid inlet plate 131 has four inlets 131a. The inlets 131a run through the fluid inlet plate 131. In response to the action of the atmospheric pressure, the fluid can be introduced into the fluid actuating device 13 through the at least one inlet 131a. Moreover, at least one convergence channel 131b is formed on a first surface of the fluid inlet plate 131, and is in communication with the at least one inlet 131a on a second surface of the fluid inlet plate 131. Moreover, a central cavity 131c is located at the intersection of the convergence channels 131b. The central cavity 131c is in communication with the at least one convergence channel 131b, such that the fluid entered by the at least one inlet 131a would be introduced into the at least one convergence channel 131b and is guided to the central cavity 131c. Consequently, the fluid can be transferred by the fluid actuating device 13. In this embodiment, the at least one inlet 131a, the at least one convergence channel 131b and the central cavity 131c of the fluid inlet plate 131 are integrally formed in one piece. The central cavity 131c is a convergence chamber for temporarily storing the fluid. Preferably but not exclusively, the fluid inlet plate 131 is made of a stainless steel. Moreover, the depth of the convergence chamber defined by the central cavity 131c is equal to the depth of the at least one convergence channel 131b. The resonance plate 132 is made of a flexible material. The resonance plate 132 comprises a central aperture 132c disposed corresponding to the central cavity 131c of the fluid inlet plate 131 for allowing the fluid to be transferred therethrough. Preferably but not exclusively, the resonance plate 132 is made of copper.

The piezoelectric actuator 133 includes a suspension plate 1331, an outer frame 1332, at least one bracket 1333 and a piezoelectric plate 1334. The piezoelectric plate 1334 is attached on a first surface 1331c of the suspension plate 1331. In response to an applied voltage, the piezoelectric plate 1334 would be subjected to a deformation. When the piezoelectric plate 1334 is subjected to the deformation, the suspension plate 1331 is driven to undergo bending vibration. The at least one bracket 1333 is connected between the suspension plate 1331 and the outer frame 1332, while the two ends of the bracket 1333 are connected with the outer frame 1332 and the suspension plate 1331 respectively so that the bracket 1333 can elastically support the suspension plate 1331. At least one vacant space 1335 is formed between the bracket 1333, the suspension plate 1331 and the outer frame 1332. The at least one vacant space 1335 is in communication with a fluid channel for allowing the fluid to go through. The type of the suspension plate 1331 and the outer frame 1332 and the type and the number of the at least one bracket 1333 may be varied according to the practical requirements. The outer frame 1332 is arranged around the suspension plate 1331. Moreover, a conducting pin 1332c is protruded outwardly from the outer frame 1332 so as to be electrically connected with an external circuit (not shown).

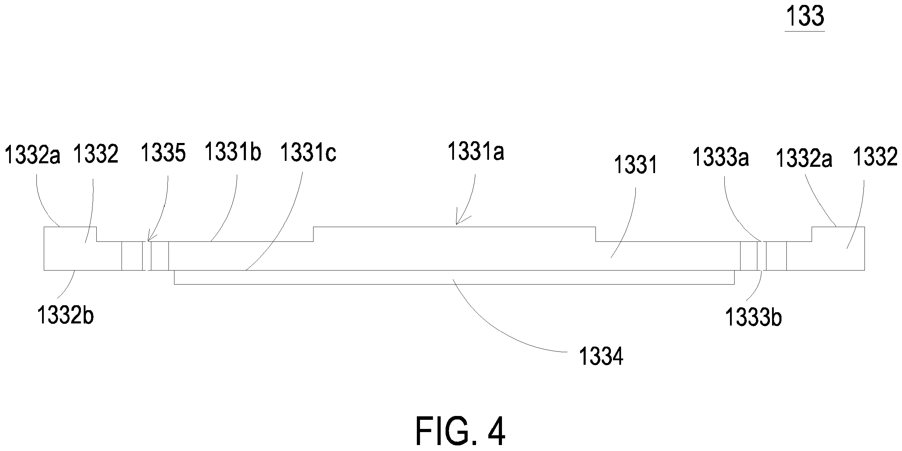

As shown in FIG. 4, the suspension plate 1331 has a bulge 1331a that makes the suspension plate 1331 a stepped structure. The bulge 1331a is formed on a second surface 1331b of the suspension plate 1331. The bulge 1331a may be a circular convex structure. A top surface of the bulge 1331a of the suspension plate 1331 is coplanar with a second surface 1332a of the outer frame 1332, while the second surface 1331b of the suspension plate 1331 is coplanar with a second surface 1333a of the bracket 1333. Moreover, there is a drop of specified amount from the bulge 1331a of the suspension plate 1331 (or the second surface 1332a of the outer frame 1332) to the second surface 1331b of the suspension plate 1331 (or the second surface 1333a of the bracket 1333). A first surface 1331c of the suspension plate 1331, a first surface 1332b of the outer frame 1332 and a first surface 1333b of the bracket 1333 are coplanar with each other. The piezoelectric plate 1334 is attached on the first surface 1331c of the suspension plate 1331. In some other embodiments, the suspension plate 1331 may be a square plate structure with two flat surfaces, but the type of the suspension plate 1331 may be varied according to the practical requirements. In this embodiment, the suspension plate 1331, the at least bracket 1333 and the outer frame 1332 are integrally formed and produced by using a metal plate (e.g., a stainless steel plate). In an embodiment, the length of a side of the piezoelectric plate 1334 is smaller than the length of a side of the suspension plate 1331. In some embodiments, the length of a side of the piezoelectric plate 1334 is equal to the length of a side of the suspension plate 1331. Similarly, the piezoelectric plate 1334 is a square plate structure to have the same shape as the suspension plate 1331.

Please refer to FIG. 3A. In an embodiment, in the fluid actuating device 13, the first insulation plate 134a, the conducting plate 135 and the second insulation plate 134b are stacked on each other sequentially and located under the piezoelectric actuator 133. The profiles of the first insulation plate 134a, the conducting plate 135 and the second insulation plate 134b substantially match the profile of the outer frame 1332 of the piezoelectric actuator 133. The first insulation plate 134a and the second insulation plate 134b are made of an insulating material (e.g. a plastic material) for providing insulating efficacy. The conducting plate 135 is made of an electrically conductive material (e.g. a metallic material) for providing electrically conducting efficacy. Moreover, the conducting plate 135 has a conducting pin 135a so as to be electrically connected with an external circuit (not shown).

Please refer to FIG. 5. In an embodiment, the fluid inlet plate 131, the resonance plate 132, the piezoelectric actuator 133, the first insulation plate 134a, the conducting plate 135 and the second insulation plate 134b of the fluid actuating device 13 are stacked on each other sequentially. Moreover, there is a gap h between the resonance plate 132 and the outer frame 1332 of the piezoelectric actuator 133, which is formed and maintained by a filler (e.g. a conductive adhesive) inserted therein in this embodiment. The gap h ensures the proper distance between the resonance plate 132 and the bulge 1331a of the suspension plate 1331 of the piezoelectric actuator 133, so that the fluid can be transferred quickly, the contact interference is reduced and the generated noise is largely reduced. In some embodiments, the height of the outer frame 1332 of the piezoelectric actuator 133 is increased, so that the gap is formed between the resonance plate 132 and the piezoelectric actuator 133.

Please refer to FIG. 3A, FIG. 3B and FIG. 5. After the fluid inlet plate 131, the resonance plate 132 and the piezoelectric actuator 133 are combined together, a movable part 132a and a fixed part 132b of the resonance plate 132 are defined, wherein the movable part 132a is located around the central aperture 132c. A convergence chamber for converging the fluid is defined by the movable part 132a of the resonance plate 132 and the fluid inlet plate 131 collaboratively. Moreover, a first chamber 130 is formed between the resonance plate 132 and the piezoelectric actuator 133 for temporarily storing the fluid. Through the central aperture 132c of the resonance plate 132, the first chamber 130 is in communication with the central cavity 131c of the fluid inlet plate 131. The peripheral regions of the first chamber 130 are in communication with the fluid channel through the vacant space 1335 between the brackets 1333 of the piezoelectric actuator 133.

Please refer to FIG. 3A, FIG. 3B, FIG. 5 and FIGS. 6A to 6E. The actions of the fluid actuating device 13 will be described as follows. When the fluid actuating device 13 is enabled, the piezoelectric actuator 133 vibrates along a vertical direction in a reciprocating manner by using the bracket 1333 as a fulcrum. Please refer to FIG. 6A. When the piezoelectric actuator 133 is vibrating, resonance between the piezoelectric actuator 133 and the resonance plate 132 occurs because the resonance plate 132 is light and thin. Therefore, the resonance plate 132 also vibrates along the vertical direction in the reciprocating manner. More especially, the region of the resonance plate 132 corresponding to the central cavity 131c of the fluid inlet plate 131, which is also referred to as the movable part 132a, is subjected to curvy deformation and driven to undergo bending vibration. When the piezoelectric actuator 133 vibrates downwardly, the movable part 132a of the resonance plate 132 is pushed by the fluid and driven by the vibration of the piezoelectric actuator 133 to be subjected to downward curvy deformation. Meanwhile, the fluid is fed into the at least one inlet 131a of the fluid inlet plate 131, and transferred to the central cavity 131c of the fluid inlet plate 131 through the at least one convergence channel 131b. Then, the fluid is transferred through the central aperture 132c of the resonance plate 132 corresponding to the central cavity 131c, and introduced downwardly into the first chamber 130. Afterwards, the resonance plate 132 reciprocates vertically in response to the vibration of the piezoelectric actuator 133 due to the resonance of the resonance plate 132.

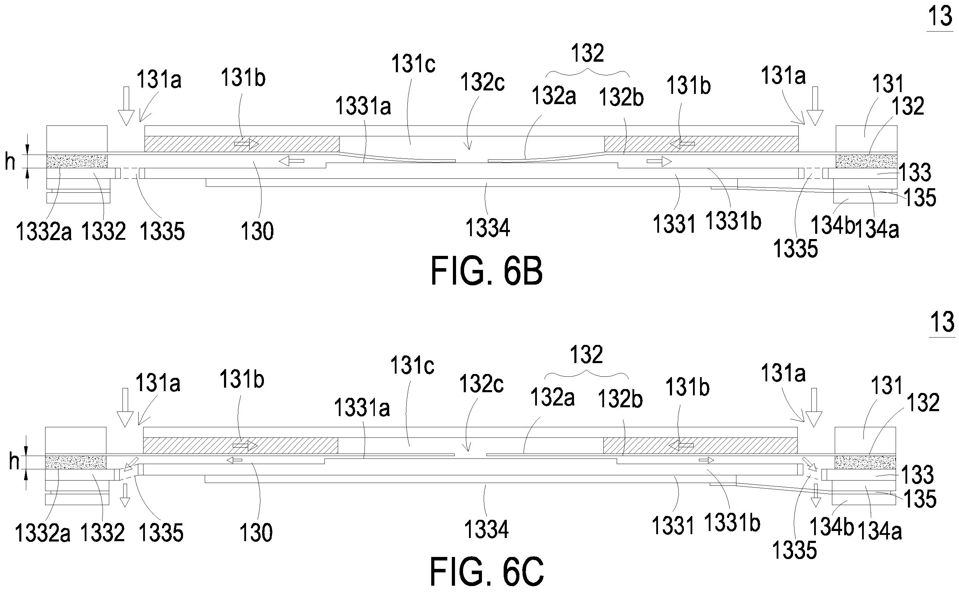

As shown in FIG. 6B, during the vibration of the movable part 132a of the resonance plate 132, the movable part 132a moves down till being contacted with the bulge 1331a of the suspension plate 1331 of the piezoelectric actuator 133. Meanwhile, the gap of the convergence chamber between the region of the suspension plate 1331 excluding the bulge 1331a and the fixed part 132b of the resonance plate 132, is not reduced. Due to the deformation of the resonance plate 132, the volume of the first chamber 130 is shrunken and a middle communication space of the first chamber 130 is closed. Under this circumstance, the pressure gradient occurs to push the fluid in the first chamber 130 moving toward peripheral regions of the first chamber 130 and flowing downwardly through the vacant space 1335 of the piezoelectric actuator 133.

As shown in FIG. 6C, the movable part 132a of the resonance plate 132 is undergoing bending vibration and bends upwardly to return to an original position, and the piezoelectric actuator 133 is driven to vibrate upwardly, thus shrinking the volume of the first chamber 130. Due to upwardly motion of the piezoelectric actuator 133, the fluid in the first chamber 130 is pushed toward peripheral regions. Meanwhile, ambient fluid is continuously fed into the at least one inlet 131a of the fluid inlet plate 131, and transferred to the central cavity 131c.

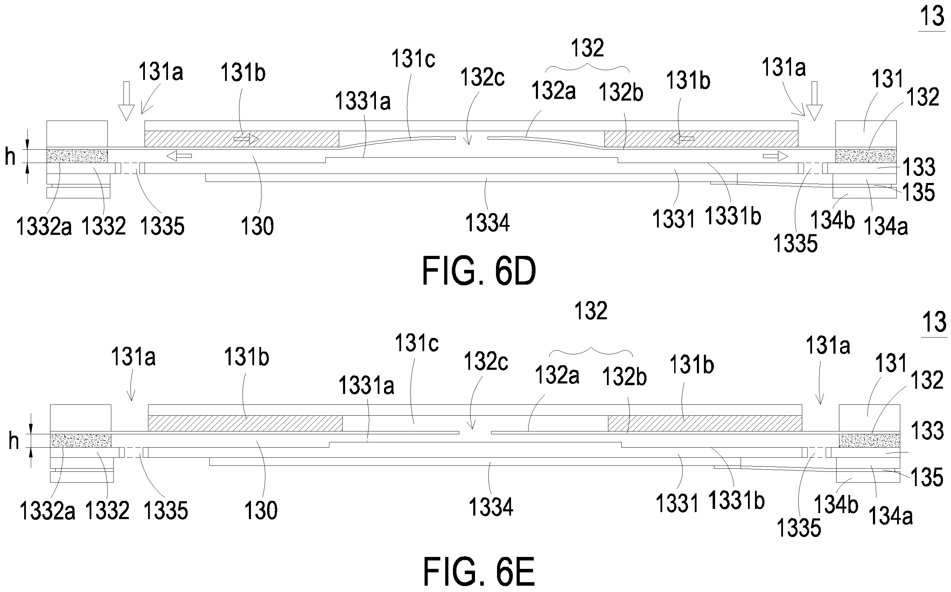

Then, as shown in FIG. 6D, the resonance plate 132 moves upwardly due to the resonance of the upward motion of the piezoelectric actuator 133. That is, the movable part 132a of the resonance plate 132 vibrates upwardly as the piezoelectric actuator 133. Consequently, the fluid is restrained from flowing into the at least one inlet 131a of the fluid inlet plate 131 and being transferred to the central cavity 131c.

As shown in FIG. 6E, the movable part 132a of the resonance plate 132 has returned to its original position. When the resonance plate 132 is reciprocating vertically, the gap h between the resonance plate 132 and the piezoelectric actuator 133 is helpful to increase the amplitude of vibration of the resonance plate 132. That is, the thickness of the gap h between the resonance plate 132 and the piezoelectric actuator 133 affects the amplitude of vibration of the resonance plate 132. Consequently, a pressure gradient is generated in the fluid guiding channels of the fluid actuating device 13 to facilitate high-speed flow of the fluid. Moreover, since there is an impedance difference between the feeding direction and the exiting direction, the fluid can be transmitted from the inlet side to the outlet side. Moreover, even if the outlet side has a gas pressure, the fluid actuating device 13 still has the capability of pushing the fluid to the fluid channel as achieving the silent efficacy.

The steps of FIGS. 6A to 6E are repeatedly done. Consequently, the ambient fluid is transferred by the fluid actuating device 13 from the outside to the inside.

After the fluid inlet plate 131, the resonance plate 132, the piezoelectric actuator 133, the first insulation plate 134a, the conducting plate 135 and the second insulation plate 134b are stacked on each other sequentially, the fluid actuating device 13 is assembled. After the fluid actuating device 13 is installed on the carrier 11, the at least one fluid channel (not shown) is arranged between the fluid actuating device 13 and the carrier 11. The fluid channel is arranged beside one lateral side of the sensor 12. When the fluid actuating device 13 is enabled to compress the fluid, the fluid is transferred through the fluid channel and the fluid is sensed by the sensor 12. Since the fluid is guided to the sensor 12 by the fluid actuating device 13 at a stable flowrate, the sensor 12 can monitor the fluid to acquire the accurate result. Since the response time of the sensor 12 is reduced, the efficiency of monitoring the fluid is enhanced.

The actuating and sensing device 1 is not necessarily equipped with the power source since it is in connection with the power supply device 2 of the driving and information transmitting system, in which the power supply device 2 transfers energy to power the sensor 12 and the actuating device 13. Since the installation space of the overall modular structure is saved, the purpose of minimizing the modular structure is achieved, so that the modular structure is suitably applied to an electronic device for monitoring the air quality. Moreover, the data transceiver 16 receives a control command to enable the sensor 12 to perform sensing operation and enable the actuating device 13. After the monitored data sensed by the at least one sensor 12 is transmitted to the microprocessor 14, the monitored data is processed into an output data. The output data is transmitted to the connection device 3, so that the information carried by the output data can be displayed, stored and transmitted by the connection device 3. Consequently, the purpose of immediately displaying the monitoring information and immediately issuing the notification signal are achieved. Moreover, the output data can be transmitted to a cloud database for database construction and data integration. Consequently, the more immediate and accurate air quality information is provided for enabling an air quality notification mechanism and an air quality processing mechanism.

From the above description, the present disclosure provides a driving and information transmitting system for the actuating and sensing module. The system includes an actuating and sensing device and a power supply device. The actuating and sensing device includes at least one sensor, at least one actuating device, a microprocessor, a power controller and a data transceiver. The at least one sensor, the at least one actuating device, the microprocessor, the power controller and the data transceiver are integrated as a modular structure. The actuating device is used for driving the fluid at a stable flowrate. Consequently, the sensor monitors the fluid directly to acquire the accurate result. Moreover, since the response time of the sensor is reduced, the efficiency of monitoring the fluid is enhanced. The actuating and sensing device is not necessarily equipped with the power source since the actuating and sensing device is in connection with the power supply device, in which the power supply device transfers the energy to power the sensor and the actuating device. Since the installation space of the overall modular structure is saved, the purpose of minimizing the modular structure is achieved, so that the modular structure is suitably applied to an electronic device for monitoring the air quality.

Moreover, a data transceiver receives a control command to control the sensor and the actuating device. After a monitored data sensed by the at least one sensor is transmitted to the microprocessor, the monitored data is processed into an output data. The output data is transmitted to the connection device by the data receiver, so that the information carried by the output data can be displayed, stored and transmitted by the connection device. Consequently, the purpose of immediately displaying the monitoring information and immediately issuing the notification signal are achieved. Moreover, the output data can be transmitted to a cloud database for database construction and data integration. Consequently, the air quality information can be provided more immediately and accurately for enabling an air quality notification mechanism and an air quality processing mechanism.

## Claims

1. An operating and information transmitting system for an actuating and sensing module, comprising:
an actuating and sensing device (1) comprising a carrier (11), at least one sensor (12), at least one fluid actuating device (13), a microprocessor (14), a power controller (15) and a data transceiver (16), wherein the at least one sensor (12), the at least one fluid actuating device (13), the microprocessor (14), the power controller (15) and the data transceiver (16) are integrated into the carrier (11) to be a modular structure;
a power supply device (2) configured to transfer an energy to the power controller (15), so that the power controller (15) receives the energy and enables the at least one sensor (12) and the at least one fluid actuating device (13); and
a connection device (3) configured to display, store and transmit an output data,
wherein after a monitored data sensed by the at least one sensor (12) is transmitted to the microprocessor (14), the monitored data is processed into an output data by the microprocessor (14), wherein the output data is received by the data transceiver (16), and the output data is transmitted from the data transceiver (16) to the connection device (3), wherein a control command from the connection device (3) is received by the data transceiver (16), and the control command is transmitted to the microprocessor (14) to control the at least one sensor (12) to perform a sensing operation and enable the at least one fluid actuating device (13).

2. The operating and information transmitting system for the actuating and sensing module according to claim 1, wherein the connection device (3) is connected with a notification processing system (31) to enable an air quality notification mechanism, wherein the air quality notification mechanism is to provide an instant air quality map to inform people to avoid away or to wear masks.

3. The operating and information transmitting system for the actuating and sensing module according to claim 1, wherein the connection device (3) is connected with a notification processing device (32) to enable an air quality processing mechanism, wherein the air quality processing mechanism is to enable an air cleaner or an air-conditioner to clean the air.

4. The operating and information transmitting system for the actuating and sensing module according to any one of claim 2 to claim 3, wherein the connection device (3) is a portable electronic device with a wireless communication module.

5. The operating and information transmitting system for the actuating and sensing module according to claim 1, further comprising a networking relay station (4), wherein the output data is transmitted from the connection device (3) to the networking relay station (4).

6. The operating and information transmitting system for the actuating and sensing module according to claim 5, further comprising a cloud data processor (5), wherein after the output data is transmitted from the networking relay station (4) to the cloud data processor (5), the output data is processed by and stored in the cloud data processor (5).

7. The operating and information transmitting system for the actuating and sensing module according to claim 6, wherein after the output data is processed by the cloud data processor (5), the cloud data processor (5) issues a notification signal to the networking relay station (4) and then transmits the notification signal to the connection device (3), wherein the connection device (3) is connected with a notification processing system (31) to enable an air quality notification mechanism, wherein the air quality notification mechanism is to provide an instant air quality map to inform people to avoid away or to wear masks.

8. The operating and information transmitting system for the actuating and sensing module according to claim 6, wherein after the output data is processed by the cloud data processor (5), the cloud data processor (5) issues a notification signal to the networking relay station (4) and then transmits the notification signal to the connection device (3), wherein the connection device (3) is connected with a notification processing device (32) to enable an air quality processing mechanism, wherein the air quality processing mechanism is to enable an air cleaner or an air-conditioner to clean the air.

9. The operating and information transmitting system for the actuating and sensing module according to any one of claim 7 and claim 8, wherein the connection device (3) is a portable electronic device with a wireless communication module.

10. The operating and information transmitting system for the actuating and sensing module according to claim 6, further comprising a second connection device (6), wherein after the second connection device (6) issues the control command to the cloud data processor (5) through the networking relay station (4), the control command is transmitted from the cloud data processor (5) to the connection device (3) through the networking relay station (4), after which the control command is transmitted by the connection device (3) to the data transceiver (16).

11. The operating and information transmitting system for the actuating and sensing module according to claim 1, wherein the sensor (12) comprises at least one selected from the group consisting of a gas sensor, an oxygen sensor, a carbon monoxide sensor, a carbon dioxide sensor, a temperature sensor, a liquid sensor, a humidity sensor, an ozone sensor, a particulate sensor, a volatile organic compound sensor and a light sensor.

12. The operating and information transmitting system for the actuating and sensing module according to claim 1, wherein the fluid actuating device (13) is a MEMS pump.

13. The operating and information transmitting system for the actuating and sensing module according to claim 1, wherein the fluid actuating device (13) is a piezoelectric pump, the piezoelectric pump comprises:
a fluid inlet plate (131) comprising at least one inlet (131a), at least one convergence channel (131b) and a central cavity (131c), wherein a convergence chamber is defined by the central cavity (131c), and the at least one convergence channel (131b) spatially corresponds to the at least one inlet (131a), wherein after a fluid is introduced into the at least one convergence channel (131b) through the at least one inlet (131a), the fluid is guided by the at least one convergence channel (131b) and converged to the convergence chamber;
a resonance plate (132) having a central aperture (132c) spatially corresponding to the convergence chamber, the resonance plate (132) comprising a movable part (132a) around the central aperture (132c); and
a piezoelectric actuator (133) spatially corresponding to the resonance plate (132), wherein a gap (h) is formed between the resonance plate (132) and the piezoelectric actuator (133) to define a first chamber (130), wherein when the piezoelectric actuator (133) is enabled, the fluid is fed into the actuating device (13) through the at least one inlet (131a) of the fluid inlet plate (131), converged to the central cavity (131c) through the at least one convergence channel (131b), transferred through the central aperture (132c) of the resonance plate (132), and introduced into the first chamber (130), wherein the fluid is transferred through a resonance between the piezoelectric actuator (133) and the movable part (132a) of the resonance plate (132).

14. The operating and information transmitting system for the actuating and sensing module according to claim 13, wherein the piezoelectric actuator (133) comprises:
a suspension plate (1331) having a first surface (1331c) and an opposing second surface (1331b), wherein the suspension plate (1331) is permitted to undergo a bending vibration;
an outer frame (1332) arranged around the suspension plate (1331);
at least one bracket (1333) connected between the suspension plate (1331) and the outer frame (1332) for elastically supporting the suspension plate (1331); and
a piezoelectric plate (1334), wherein a length of a side of the piezoelectric plate (1334) is smaller than or equal to a length of a side of the suspension plate (1331), and the piezoelectric plate (1334) is attached on the first surface (1331c) of the suspension plate (1331), wherein when a voltage is applied to the piezoelectric plate (1334), the suspension plate (1331) is driven to undergo the bending vibration.

## Patentansprüche

1. Betriebs- und Informationsübertragungssystem für ein Betätigungs- und Erfassungsmodul, umfassend:
eine Betätigungs- und Erfassungsvorrichtung (1) mit einem Träger (11), mindestens einem Sensor (12), mindestens einer Fluid-Betätigungsvorrichtung (13), einem Mikroprozessor (14), einer Leistungssteuerung (15) und einem Daten-Transceiver (16), wobei der mindestens eine Sensor (12), die mindestens eine Fluid-Betätigungsvorrichtung (13), der Mikroprozessor (14), die Leistungssteuerung (15) und der Daten-Transceiver (16) in dem Träger (11) integriert sind, um eine modulare Struktur zu bilden;
eine Leistungsversorgungsvorrichtung (2), die ausgestaltet ist, um Leistung zur Leistungssteuerung (15) zu übertragen, so dass die Leistungssteuerung (15) die Leistung empfängt und den mindestens einen Sensor (12) und die mindestens eine Fluid-Betätigungsvorrichtung (13) aktiviert; und
eine Verbindungsvorrichtung (3), die ausgestaltet ist, um Ausgangsdaten anzuzeigen, zu speichern und zu übertragen,
wobei, nachdem überwachte Daten, die von dem mindestens einen Sensor (12) erfasst wurden, zum Mikroprozessor (14) übertragen werden, die überwachten Daten durch den Mikroprozessor (14) zu Ausgangsdaten verarbeitet werden, wobei die Ausgangsdaten durch den Daten-Transceiver (16) empfangen werden, und die Ausgangsdaten vom Daten-Transceiver (16) zur Verbindungsvorrichtung (3) übertragen werden, wobei ein Steuerbefehl von der Verbindungsvorrichtung (3) durch den Daten-Transceiver (16) empfangen werden, und der Steuerbefehl zum Mikroprozessor (14) übertragen wird, um den mindestens einen Sensor (12) zu steuern, um einen Erfassungsvorgang durchzuführen und die mindestens eine Fluid-Betätigungsvorrichtung (13) zu aktivieren.

2. Betriebs- und Informationsübertragungssystem für das Betätigungs- und Erfassungsmodul nach Anspruch 1, wobei die Verbindungsvorrichtung (3) mit einem Benachrichtigungsverarbeitungssystem (31) verbunden ist, um einen Luftqualitätsbenachrichtigungsmechanismus zu aktivieren, wobei der Luftqualitätsbenachrichtigungsmechanismus ausgestaltet ist, um einen aktuellen Luftqualitätsplan zur Verfügung zu stellen, um Menschen zu informieren, um sich zu entfernen oder Masken zu tragen.

3. Betriebs- und Informationsübertragungssystem für das Betätigungs- und Erfassungsmodul nach Anspruch 1, wobei die Verbindungsvorrichtung (3) mit einer Benachrichtigungsverarbeitungsvorrichtung (32) verbunden ist, um einen Luftqualitätsverarbeitungsmechanismus zu aktivieren, wobei der Luftqualitätsverarbeitungsmechanismus ausgestaltet ist, um einen Luftreiniger oder eine Klimaanlage zu aktivieren, um die Luft zu reinigen.

4. Betriebs- und Informationsübertragungssystem für das Betätigungs- und Erfassungsmodul nach einem von Anspruch 2 bis Anspruch 3, wobei die Verbindungsvorrichtung (3) eine tragbare elektronische Vorrichtung mit einem drahtlosen Kommunikationsmodul ist.

5. Betriebs- und Informationsübertragungssystem für das Betätigungs- und Erfassungsmodul nach Anspruch 1, außerdem mit einer Netzwerk-Relaisstation (4), wobei die Ausgangsdaten von der Verbindungsvorrichtung (3) zur Netzwerk-Relaisstation (4) übertragen werden.

6. Betriebs- und Informationsübertragungssystem für das Betätigungs- und Erfassungsmodul nach Anspruch 5, außerdem mit einem Cloud-Datenprozessor (5), wobei, nachdem die Ausgangsdaten von der Netzwerk-Relaisstation (4) zum Cloud-Datenprozessor (5) übertragen wurden, die Ausgangsdaten durch den Cloud-Datenprozessor (5) verarbeitet und in diesem gespeichert werden.

7. Betriebs- und Informationsübertragungssystem für das Betätigungs- und Erfassungsmodul nach Anspruch 6, wobei, nachdem die Ausgangsdaten durch den Cloud-Datenprozessor (5) verarbeitet wurden, der Cloud-Datenprozessor (5) ein Benachrichtigungssignal an die Netzwerk-Relaisstation (4) ausgibt und dann das Benachrichtigungssignal an die Verbindungsvorrichtung (3) überträgt, wobei die Verbindungsvorrichtung (3) mit einem Benachrichtigungsverarbeitungssystem (31) verbunden ist, um einen Luftqualitätsbenachrichtigungsmechanismus zu aktivieren, wobei der Luftqualitätsbenachrichtigungsmechanismus ausgestaltet ist, um einen aktuellen Luftqualitätsplan zur Verfügung zu stellen, um Menschen zu informieren, um sich zu entfernen oder Masken zu tragen.

8. Betriebs- und Informationsübertragungssystem für das Betätigungs- und Erfassungsmodul nach Anspruch 6, wobei, nachdem die Ausgangsdaten durch den Cloud-Datenprozessor (5) verarbeitet wurden, der Cloud-Datenprozessor (5) ein Benachrichtigungssignal an die Netzwerk-Relaisstation (4) ausgibt und dann das Benachrichtigungssignal an die Verbindungsvorrichtung (3) überträgt, wobei die Verbindungsvorrichtung (3) mit einer Benachrichtigungsverarbeitungsvorrichtung (32) verbunden ist, um einen Luftqualitätsverarbeitungsmechanismus zu aktivieren, wobei der Luftqualitätsverarbeitungsmechanismus ausgestaltet ist, um einen Luftreiniger oder eine Klimaanlage zu aktivieren, um die Luft zu reinigen.

9. Betriebs- und Informationsübertragungssystem für das Betätigungs- und Erfassungsmodul nach einem von Anspruch 7 und Anspruch 8, wobei die Verbindungsvorrichtung (3) eine tragbare elektronische Vorrichtung mit einem drahtlosen Kommunikationsmodul ist.

10. Betriebs- und Informationsübertragungssystem für das Betätigungs- und Erfassungsmodul nach Anspruch 6, außerdem mit einer zweiten Verbindungsvorrichtung (6), wobei, nachdem die zweite Verbindungsvorrichtung (6) den Steuerbefehl durch die Netzwerk-Relaisstation (4) zum Cloud-Datenprozessor (5) ausgegeben hat, der Steuerbefehl von dem Cloud-Datenprozessor (5) über die Netzwerk-Relaisstation (4) zur Verbindungsvorrichtung (3) übertragen wird, wonach der Steuerbefehl über die Verbindungsvorrichtung (3) zum Daten-Transceiver (16) übertragen wird.

11. Betriebs- und Informationsübertragungssystem für das Betätigungs- und Erfassungsmodul nach Anspruch 1, wobei der Sensor (12) mindestens einen Sensor umfasst, der aus der Gruppe ausgewählt ist, die einen Gassensor, einen Sauerstoffsensor, einen Kohlenmonoxidsensor, einen Kohlendioxidsensor, einen Temperatursensor, einen Flüssigkeitssensor, einen Feuchtigkeitssensor, einen Ozonsensor, einen Partikelsensor, einen Sensor für flüchtige organische Verbindungen und einen Lichtsensor umfasst.

12. Betriebs- und Informationsübertragungssystem für das Betätigungs- und Erfassungsmodul nach Anspruch 1, wobei die Fluid-Betätigungsvorrichtung (13) eine MEMS-Pumpe ist.

13. Betriebs- und Informationsübertragungssystem für das Betätigungs- und Erfassungsmodul nach Anspruch 1, wobei die Fluid-Betätigungsvorrichtung (13) eine piezoelektrische Pumpe ist, wobei die piezoelektrische Pumpe umfasst:
eine Fluid-Einlassplatte (131) mit mindestens einem Einlass (131a), mindestens einem Konvergenzkanal (131b) und einer zentralen Kavität (131c), wobei eine Konvergenzkammer durch die zentrale Kavität (131c) gebildet ist, und der mindestens eine Konvergenzkanal (131b) räumlich dem mindestens einen Einlass (131a) entspricht, wobei, nachdem ein Fluid durch den mindestens einen Einlass (131a) in den mindestens einen Konvergenzkanal (131b) eingeleitet wurde, das Fluid durch den mindestens einen Konvergenzkanal (131b) geleitet und zu der Konvergenzkammer konvergiert wird;
eine Resonanzplatte (132) mit einer zentralen Öffnung (132c), die räumlich der Konvergenzkammer entspricht, wobei die Resonanzplatte (132) einen beweglichen Abschnitt (132a) um die zentrale Öffnung (132c) herum aufweist; und
einen piezoelektrischen Aktuator (133), der räumlich der Resonanzplatte (132) entspricht, wobei ein Spalt (h) zwischen der Resonanzplatte (132) und dem piezoelektrischen Aktuator (133) gebildet ist, um eine erste Kammer (130) zu definieren, wobei, wenn der piezoelektrische Aktuator (133) aktiviert wird, das Fluid durch den mindestens einen Einlass (131a) der Fluid-Einlassplatte (131) in die Betätigungsvorrichtung (13) geleitet wird, durch den mindestens einen Konvergenzkanal (131b) zu der zentralen Kavität (131c) konvergiert wird, durch die zentrale Öffnung (132c) der Resonanzplatte (132) übertragen wird, und in die erste Kammer (130) eingeleitet wird, wobei das Fluid durch eine Resonanz zwischen dem piezoelektrischen Aktuator (133) und dem beweglichen Abschnitt (132a) der Resonanzplatte (132) übertragen wird.

14. Betriebs- und Informationsübertragungssystem für das Betätigungs- und Erfassungsmodul nach Anspruch 13, wobei der piezoelektrische Aktuator (133) umfasst:
eine Aufhängungsplatte (1331) mit einer ersten Fläche (1331c) und einer gegenüberliegenden zweiten Fläche (1331b), wobei es der Aufhängungsplatte (1331) möglich ist, eine Biegevibration zu erfahren;
einen äußeren Rahmen (1332), der um die Aufhängungsplatte (1331) herum angeordnet ist;
mindestens eine Halterung (1333), die zwischen der Aufhängungsplatte (1331) und dem äußerem Rahmen (1332) verbunden ist, um die Aufhängungsplatte (1331) elastisch abzustützen; und
eine piezoelektrische Platte (1334), wobei eine Länge von einer Seite der piezoelektrischen Platte (1334) kleiner oder gleich einer Länge von einer Seite der Aufhängungsplatte (1331) ist, und die piezoelektrische Platte (1334) an der erste Fläche (1331c) der Aufhängungsplatte (1331) angebracht ist, wobei, wenn eine Spannung an die piezoelektrische Platte (1334) angelegt wird, die Aufhängungsplatte (1331) angetrieben wird, um der Biegevibration zu erfahren.

## Revendications

1. Système de pilotage et de transmission d'informations pour un module d'actionnement et de détection, comprenant:
un dispositif d'actionnement et de détection (1) comprenant un support (11), au moins un capteur (12), au moins un dispositif d'actionnement de fluide (13), un microprocesseur (14), un contrôleur d'alimentation (15) et un émetteur-récepteur de données (16), l'au moins un capteur (12), l'au moins un dispositif d'actionnement de fluide (13), le microprocesseur (14), le contrôleur d'alimentation (15) et l'émetteur-récepteur de données (16) étant intégrés dans le support (11) pour constituer une structure modulaire;
un dispositif d'alimentation électrique (2) configuré pour transférer de l'énergie au contrôleur d'alimentation (15), de manière que le contrôleur d'alimentation (15) reçoive l'énergie et active l'au moins un capteur (12) et l'au moins un dispositif d'actionnement de fluide (13); et
un dispositif de connexion (3) configuré pour afficher, stocker et transmettre des données de sortie,
dans lequel après que des données surveillées détectées par l'au moins un capteur (12) ont été transmises au microprocesseur (14), les données surveillées sont traitées pour obtenir des données de sortie par le microprocesseur (14), dans lequel les données de sortie sont reçues par l'émetteur-récepteur de données (16) et les données de sortie sont transmises de l'émetteur-récepteur de données (16) au dispositif de connexion (3), dans lequel une instruction de commande provenant du dispositif de connexion (3) est reçue par l'émetteur-récepteur de données (16), et l'instruction de commande est transmise au microprocesseur (14) pour commander l'au moins un capteur (12) afin d'effectuer une opération de détection et activer l'au moins un dispositif d'actionnement de fluide (13).

2. Système de pilotage et de transmission d'informations pour le module d'actionnement et de détection selon la revendication 1, dans lequel le dispositif de connexion (3) est connecté à un système de traitement de notification (31) pour activer un mécanisme de notification de qualité de l'air, le mécanisme de notification de qualité de l'air étant destiné à fournir une carte de qualité de l'air instantanée pour avertir les personnes qu'elles doivent s'éloigner ou porter des masques.

3. Système de pilotage et de transmission d'informations pour le module d'actionnement et de détection selon la revendication 1, dans lequel le dispositif de connexion (3) est connecté à un dispositif de traitement de notification (32) pour activer un mécanisme de traitement de qualité de l'air, le mécanisme de traitement de qualité de l'air étant destiné à activer un purificateur d'air ou un conditionneur d'air pour purifier l'air.

4. Système de pilotage et de transmission d'informations pour le module d'actionnement et de détection selon l'une quelconque des revendications 2 à 3, dans lequel le dispositif de connexion (3) est un dispositif électronique portable pourvu d'un module de communication sans fil.

5. Système de pilotage et de transmission d'informations pour le module d'actionnement et de détection selon la revendication 1, comprenant en outre une station relais de réseau (4), dans lequel les données de sortie sont transmises du dispositif de connexion (3) à la station relais de réseau (4).

6. Système de pilotage et de transmission d'informations pour le module d'actionnement et de détection selon la revendication 5, comprenant en outre un processeur de données en nuage (5), dans lequel après que les données de sortie ont été transmises de la station relais de réseau (4) au processeur de données en nuage (5), les données de sortie sont traitées par le processeur de données en nuage (5) et stockées dedans.

7. Système de pilotage et de transmission d'informations pour le module d'actionnement et de détection selon la revendication 6, dans lequel après que les données de sortie ont été traitées par le processeur de données en nuage (5), le processeur de données en nuage (5) délivre un signal de notification à la station relais de réseau (4) et transmet ensuite le signal de notification au dispositif de connexion (3), le dispositif de connexion (3) étant connecté à un système de traitement de notification (31) pour activer un mécanisme de notification de qualité de l'air, le mécanisme de notification de qualité de l'air étant destiné à fournir une carte de qualité de l'air instantanée pour avertir les personnes qu'elles doivent s'éloigner ou porter des masques.

8. Système de pilotage et de transmission d'informations pour le module d'actionnement et de détection selon la revendication 6, dans lequel après que les données de sortie ont été traitées par le processeur de données en nuage (5), le processeur de données en nuage (5) délivre un signal de notification à la station relais de réseau (4) et transmet ensuite le signal de notification au dispositif de connexion (3), le dispositif de connexion (3) étant connecté à un dispositif de traitement de notification (32) pour activer un mécanisme de traitement de qualité de l'air, le mécanisme de traitement de qualité de l'air étant destiné à activer un purificateur d'air ou un conditionneur d'air pour purifier l'air.

9. Système de pilotage et de transmission d'informations pour le module d'actionnement et de détection selon l'une quelconque des revendications 7 et 8, dans lequel le dispositif de connexion (3) est un dispositif électronique portable pourvu d'un module de communication sans fil.

10. Système de pilotage et de transmission d'informations pour le module d'actionnement et de détection selon la revendication 6, comprenant en outre un second dispositif de connexion (6), dans lequel après que le second dispositif de connexion (6) a délivré l'instruction de commande au processeur de données en nuage (5) par l'intermédiaire de la station relais de réseau (4), l'instruction de commande est transmise du processeur de données en nuage (5) au dispositif de connexion (3) par l'intermédiaire de la station relais de réseau (4), après quoi l'instruction de commande est transmise par le dispositif de connexion (3) à l'émetteur-récepteur de données (16).

11. Système de pilotage et de transmission d'informations pour le module d'actionnement et de détection selon la revendication 1, dans lequel le capteur (12) comprend au moins un capteur sélectionné dans le groupe constitué d'un capteur de gaz, d'un capteur d'oxygène, d'un capteur de monoxyde de carbone, d'un capteur de dioxyde de carbone, d'un capteur de température, d'un capteur de liquide, d'un capteur d'humidité, d'un capteur d'ozone, d'un capteur de particules, d'un capteur de composés organiques volatils et d'un capteur de lumière.

12. Système de pilotage et de transmission d'informations pour le module d'actionnement et de détection selon la revendication 1, dans lequel le dispositif d'actionnement de fluide (13) est une pompe MEMS.

13. Système de pilotage et de transmission d'informations pour le module d'actionnement et de détection selon la revendication 1, dans lequel le dispositif d'actionnement de fluide (13) est une pompe piézoélectrique, la pompe piézoélectrique comprenant:
une plaque d'entrée de fluide (131) comprenant au moins une entrée (131a), au moins un canal de convergence (131b) et une cavité centrale (131c), une chambre de convergence étant délimitée par la cavité centrale (131c), et l'au moins un canal de convergence (131b) correspondant spatialement à ladite au moins une entrée (131a), un fluide, après avoir été introduit dans l'au moins un canal de convergence (131b) par l'intermédiaire de l'au moins une entrée (131a), étant guidé par l'au moins un canal de convergence (131b) et amené à converger vers la chambre de convergence;
une plaque de résonance (132) ayant une ouverture centrale (132c) correspondant spatialement à la chambre de convergence, la plaque de résonance (132) comprenant une partie mobile (132a) autour de l'ouverture centrale (132c); et
un actionneur piézoélectrique (133) correspondant spatialement à la plaque de résonance (132), un écartement (h) étant formé entre la plaque de résonance (132) et l'actionneur piézoélectrique (133) pour délimiter une première chambre (130), le fluide, lorsque l'actionneur piézoélectrique (133) est activé, étant amené dans le dispositif d'actionnement (13) par l'intermédiaire de l'au moins une entrée (131a) de la plaque d'entrée de fluide (131), amené à converger vers la cavité centrale (131c) par l'intermédiaire de l'au moins un canal de convergence (131b), transféré par l'intermédiaire de l'ouverture centrale (132c) de la plaque de résonance (132), et introduit dans la première chambre (130), le fluide étant transféré par le biais d'une résonance entre l'actionneur piézoélectrique (133) et la partie mobile (132a) de la plaque de résonance (132).

14. Système de pilotage et de transmission d'informations pour le module d'actionnement et de détection selon la revendication 13, dans lequel l'actionneur piézoélectrique (133) comprend:
une plaque de suspension (1331) ayant une première surface (1331c) et une seconde surface opposée (1331b), la plaque de suspension (1331) pouvant subir une vibration de flexion;
un cadre extérieur (1332) agencé autour de la plaque de suspension (1331);
au moins une patte (1333) reliée entre la plaque de suspension (1331) et le cadre extérieur (1332) pour supporter élastiquement la plaque de suspension (1331); et
une plaque piézoélectrique (1334), la longueur d'un côté de la plaque piézoélectrique (1334) étant inférieure ou égale à la longueur d'un côté de la plaque de suspension (1331), et la plaque piézoélectrique (1334) étant attachée sur la première surface (1331c) de la plaque de suspension (1331), la plaque de suspension (1331), lorsqu'une tension est appliquée à la plaque piézoélectrique (1334), étant entraînée pour subir la vibration de flexion.
